# EUROPEAN PATENT APPLICATION

(11) **EP 1 936 977 A2**
(43) Date of publication of application: **25.06.2008**
(21) Application number: 07397502.1
(22) Date of filing: 20.12.2007
(51) Int. Cl.: H04N 7/10, H04N 7/173

(54) **Amplification control of a broadband amplifier**

(30) Priority: 22.12.2006 FI 20065852
(71) Applicant: Teleste Oyj, 20660 Littoinen (FI)
(72) Inventor: Mäki, Kari, 20320, Turku (FI)
(74) Representative: Pursiainen, Timo Pekka

(57) **Abstract**

A network element adaptable to a cable television network, which element comprises several amplifier units for amplifying a forward signal to a desired value and at least one coaxial output connection for the forward signal. The network element comprises an amplification control point for entering the desired amplification value of the forward signal to the network element; and a processing unit for controlling the parameters of at lease some amplifier components comprised by the amplifier units, the values of which parameters are predetermined to be responsive to the entered amplification value.

## Description

### Field of the invention

The invention relates to cable television network amplifiers, specifically to amplification control of a broadband amplifier.

### Background of the invention

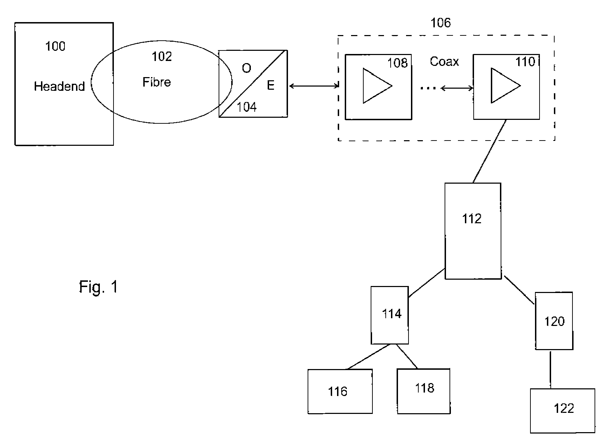

Cable television networks may be implemented with various techniques and network topologies, but currently most cable television networks are implemented as so-called HFC networks (Hybrid Fiber Coax), i.e. as combinations of a fibre network and a coaxial cable network. Figure 1 shows the general structure of a typical HFC network. Program services are introduced from the main amplifier 100 (a so-called headend) of the network via an optical fibre network 102 to a fibre node 104, which converts the optical signal to an electric signal to be relayed further in a coaxial cable network 106. Depending on the length, branching, topology, etc. of the coaxial cable network, this coaxial cable portion typically comprises one or more broadband amplifiers 108, 110 for amplifying program service signals in a heavily attenuating coaxial media. From the amplifier the program service signals are introduced to a cable network 112 of a smaller area, such as a master antenna network of an apartment building, which are typically implemented as coaxial tree or star networks. From this type of a master antenna network the signal is further relayed either via a cable modem 114 to a television receiver 116 or a computer 118, or via a so-called set-top box 120 to a television receiver 122.

When extending or updating cable television networks, it is typically necessary to connect new broadband amplifiers to the network. Thus, the personnel performing the installation must adjust the controls and settings of the amplifier correctly, which must naturally be done quickly when, for example, changing a malfunctioning amplifier to a new one. A problem in installing an amplifier is that adjusting the settings correctly is not entirely simple and straightforward. A broadband amplifier typically comprises several attenuators, signal inclination controllers and amplifiers, by means of which both the forward and reverse signals are amplified and, on the other hand, the signal levels are controlled into balance so that noise and distortion of the signal remain within allowed limits. The wider the amplification control area of the amplifier is desired, the more attenuators, signal inclination controllers and amplifiers the broadband amplifier comprises, and the more difficult it is to find an optimal setting for the controls of all these components. Thus, for example, by measuring only the output signal of the amplifier it is not possible to conclude whether the controls are in their optimum from the point of view of signal quality Thus, the installation of an amplifier requires good professional skills from the personnel, and despite of that, the installation may take an unreasonably long time.

### Brief summary of the invention

Now an improved arrangement has been developed, which enables the installation of a broadband amplifier into a cable television network significantly faster than before. As different aspects of the invention, we present a network element adaptable to a cable television network, which is characterized in what will be presented in the independent claims.

The dependent claims disclose advantageous embodiments of the invention.

The invention is based on the idea, that a network element adaptable to a cable television network is implemented, which element comprises several amplifier units for amplifying a forward signal into a desired value and at least one coaxial output connection for the forward signal. The network element according to the invention comprises an amplification control point for entering the desired amplification value of the forward signal to the network element; and a processing unit for controlling the parameters of at least some amplifier components comprised by the amplifier units, the values of which parameters are predetermined to be responsive to the entered amplification value

In other words, all the amplifiers of the broadband amplifier are controlled according to a predetermined algorithm so that the person performing the installation selects the desired amplification, for example, on the basis of network topology and network measurements, as response to which amplification setting the microprocessor controls the parameters of each controlled amplification component to a suitable value.

In addition, according to an embodiment the network element comprises a computer program stored in a memory, which program comprises a control algorithm for controlling the parameters of said amplifier components, which computer program executed in a processing unit is arranged to receive the entered amplification value; to select a control setting corresponding to the entered amplification value; and to control the parameters of at least some amplifier components comprised by said amplifier units according to the selected control setting.

Further, according to an embodiment the network element also comprises several amplifier units for amplifying a reverse signal to a desired value, in which case said amplification control point is arranged to receive the desired amplification value of the reverse signal; and said processing unit is arranged to control the parameters of at least some amplifier components comprised by the reverse amplifier units to predetermined values as response to the entered amplification value.

The network element according to the invention provides significant advantages. A very significant advantage is that the installation of the broadband amplifier and especially the amplification control of the broadband amplifier becomes significantly faster. Further, a significant advantage is that the personnel performing the installation can be sure that the settings of the amplifier are accurate for other signal parameters besides the amplification as well. In addition, the procedure according to the invention can be applied not only to amplify the forward signal, but also to amplify the reverse signal.

The other aspects, embodiments and advantages of the invention will be presented later in the detailed description of the invention.

### Brief description of the drawings

The invention will now be described in more detail in connection with preferred embodiments with reference to the appended drawings, in which:
- Fig. 1: shows the general structure of a typical HFC network; and
- Fig. 2: shows a broadband amplifier according to an embodiment in a simplified block chart.

### Detailed description of the invention

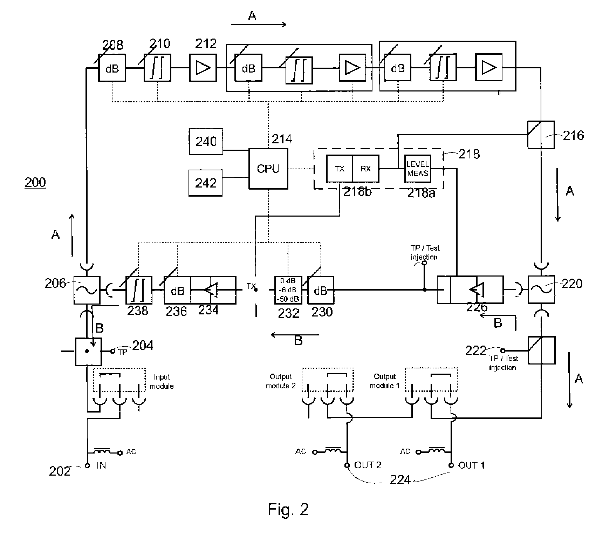

Figure 2 shows a broadband amplifier according to the invention by means of a simplified block chart. The purpose of figure 2 is to illustrate the operation of a broadband amplifier and especially a forward amplification control arrangement implemented in connection with it, and therefore, figure 2 does not necessarily show all the functional blocks of a typical broadband amplifier. In addition, it is to be noted that the amplification control arrangement according to the invention can also be implemented in an amplifier arranged in connection with a fibre node (104 in figure 1) of an HFC network, in which case the input connection of the network element comprising the amplifier can be either optical or coaxial, but there is always an coaxial output in the output. Naturally the amplifier may comprise several output connections, one or more of which can be an active output and one or more can be an output with a passive power supply. In figure 2 the route of the forward signal, i.e. from the networks to client terminals, is illustrated by the arrow A and the route of the reverse signal, i.e. from the client terminals to the service provider, is illustrated by the arrow B.

The broadband amplifier 200 according to figure 2 comprises at least one input port 202, after which has been arranged a tap for a test point 204 of the input signal. After the test point 204 of the input signal an input diplexer 206 has been arranged on the signal route, which directs the forward signal in the direction pointed by the arrow A, and the reverse signal to the direction pointed by the arrow B.

On a forward signal path the signal is introduced to the first attenuator block 208, which operates as a sensitivity controller, and from there further via a signal inclination controller 210 to a first amplifier 212. A broadband amplifier typically comprises several, for example 3 to 7 such combinations of an attenuator, signal inclination controller and amplifier, by means of which the forward signal is amplified, and on the other hand the signal levels are controlled into balance so that noise and distortion of the signal remain within allowed limits. The broadband amplifier may advantageously comprise a micro processor 214, which controls the parameters of the above-mentioned blocks, for example, on the basis of different measurement results.

The amplified and controlled forward signal output from the last amplifier is introduced to a directional coupler 216, which enables sampling from the forward signal in order to measure signal levels. The signal samples are introduced to a transponder unit 218, which comprises an interference level indicator 218a, for example a controllable RF indicator, and a transceiver unit 218b, advantageously a modem. The transponder unit inputs the samples further to the micro processor 214 to be analyzed, and on the basis of the analysis results the micro processor 214 controls the above-mentioned attenuators, signal inclination controllers and amplifiers to a suitable level. Further, on the forward signal path the signal is introduced to an output diplexer 220, which operates in a corresponding manner as the input diplexer, and from there further to a tap for a test point 222 of the output signal. In order to input the forward signal further to a cable television network the broadband amplifier comprises at least one, but advantageously several coaxial output ports 224.

For a reverse signal the broadband amplifier comprises, similarly to the forward signal path, attenuators, signal inclination controllers and amplifiers for controlling the reverse signal to a suitable level. The reverse signal route comprises an amplifier 226 arranged after an output diplexer 220, in connection with which amplifier is arranged a tap 228 for the test point of the reverse signal, as well as a directional coupler, by means of which it is possible to enter samples from the reverse signal to a controllable RF indicator 218a comprised by a transponder unit 218, and further to a micro processor 214 to be analyzed. Further, the reverse signal route may comprise one or more attenuators 230, 236, a second amplifier 234, a signal inclination controller 238 and a reverse signal interruption point 232.

The present invention relates especially to amplification control of a forward signal (signal route A), but according to an embodiment the same principle can also be applied for amplification of a reverse signal, as will be described later. As mentioned above, the broadband amplifier used in cable television networks comprises several, typically at least two of the above-described combinations of an attenuator, a signal inclination controller and an amplifier, which combinations may be called amplifier units (figure 2 shows three amplifier units). In practice, the number of amplifier units depends on how high an amplification is desired from the broadband amplifier, when necessary. If, for example, an amplification of 40 dB is desired, at least two amplifier units are needed, but in practice, however, more, even four amplifier units. Because the components connected to amplification control are connected in series according to figure 2, the output signal of the previous component always affects the input of the next component, and by that, to the control needed Thus, it is obvious that controlling the settings of several attenuators, signal inclination controllers and amplifiers so that the desired amplification is provided to the forward signal and that at the same time the noise and distortion of the signal can be kept within allowed limits, is a very complicated and time-consuming optimization task, which is further complicated by the fact that the output signal values of the amplifier do not, as such, indicate whether the controls are accurate.

Thus, in order to expedite this optimization, a broadband amplifier is now provided, where all the amplifiers are controlled according to a predetermined algorithm. In other words, the broadband amplifier comprises, for example stored in a memory 240, advantageously in a functional connection with a micro processor 214, a computer program comprising a control algorithm, in which program each amplification value has a predetermined, optimized control setting for each amplification component to be controlled. Thus, the person performing the installation must only select the desired amplification, which, in turn, is easily concluded on the basis of the network topology of the cable television network and the network measurements, as a response to which amplification setting the micro processor 214 directs parameters of each controllable amplification component to a value according to the control algorithm.

For example, when implementing the above-described 40 dB broadband amplifier, it may comprise a control setting 1 that corresponds to a 40 dB amplification, a control setting 2 that corresponds to a 39 dB amplification, a control setting 3 that corresponds to a 38 dB amplification, etc. The control settings are advantageously pre-optimized in relation to the parameters of the amplification components so that the amplification components create the desired amplification and at the same time the noise and distortion of the signal do not exceed the allowable levels.

The broadband amplifier further comprises a control point 242 for entering the desired amplification to for the broadband amplifier. This control point 242 can be implemented in a variety of ways: it may be, for example, an independent user interface in the broadband amplifier, an access point for a portable computer, through which the setting is provided, or it may simply be one or more electro-mechanical selection switches. The person performing the installation enters the desired amplification value, for example 39 dB, via the control point 242 to the amplifier, as a response to which the computer program comprising the control algorithm and performed by a micro processor 214 first selects the control setting corresponding to the entered amplification value, in this case control setting 2, and after that controls the parameter values of the amplification components to values according to the control setting.

The same principle can be applied for controlling the amplification of a reverse signal. In other words, the broadband amplifier also comprises another control algorithm, where a predetermined, optimized control setting for each controllable amplification component exists for each reverse amplification value. The reverse control algorithm is typically simpler to implement, because the broadband amplifier usually comprises less amplification components for an reverse signal. For example, in a broadband amplifier according to figure 2 the reverse amplification control can be implemented by controlling the attenuators 230 and 236 according to the control setting determined on the basis of the control algorithm. Thus, correspondingly, the person performing the installation enters the desired reverse amplification value to the amplifier via the control point 242, as a response to which said second control algorithm first selects the control setting corresponding to the entered amplification value, and after that controls the parameter values of the attenuators 230 and 236 to values according to the control setting.

Thus, performing the installation of a broadband amplifier becomes significantly faster and especially the time used for controlling the amplification of the broadband amplifier decreases at the best to a fraction of what it was earlier. In addition, the personnel performing the installation can be sure that the controls of the amplifier are accurate for other signal parameters besides the amplification as well.

It will be obvious for a person skilled in the art that with technological developments, the basic idea of the invention can be implemented in a variety of ways. Thus, the invention and its embodiments are not limited to the above-described examples but they may vary within the scope of the claims.

## Claims

1. A network element adaptable to a cable television network, which element comprises several amplifier units for amplifying a forward signal to a desired value and at least one coaxial output connection for a forward signal; **characterized in that** the network element comprises
an amplification control point for entering the desired amplification value of the forward signal to the network element; and
a processing unit for controlling the parameters of at least some amplifier components comprised by the amplifier units, the values of which parameters are predetermined to be responsive to the entered amplification value.

2. The network according to claim 1, **characterized in that** the network element also comprises
a computer program stored in a memory, which program comprises a control algorithm for controlling the parameters of said amplifier components, which computer program when performed in the processing unit is arranged to
receive the entered amplification value;
select a control setting corresponding to the entered amplification value; and
control the parameters of at least some amplifier components comprised by said amplifier units according to the selected control setting.

3. The network element according to claim 1 or 2, **characterized in that** the network element also comprises
several amplifier units for amplifying a reverse signal to a desired value; in which case
said amplification control point is arranged to receive the desired amplification value of the reverse signal; and
said processing unit is arranged to control the parameters of at least some amplifier components comprised by the reverse amplifier units to predetermined values as response to the entered amplification value.

4. The network element according to claim 3, **characterized in that** the network element comprises
a second control algorithm for controlling the parameters of said reverse amplifier components.

5. The network element according to any of the preceding claims, **characterized in that** the network element comprises
at least three, advantageously at least four forward signal amplifier units.

6. The network element according to any of the preceding claims, **characterized in that** said amplifier units comprise one or more of the following amplifier components: an attenuator, a signal inclination controller, an amplifier.

7. The network element according to any of the preceding claims, **characterized in that**
said amplification control point is one of the following:
- an independent user interface of the network element,
- an access point for a portable computer, which is arranged to enter the desired amplification value, or
- one or more electromechanical selection switches.

8. The network element according to any of the preceding claims, **characterized in that**
the network element is a broadband amplifier adaptable to a cable television network.

9. The network element according to claim 8, **characterized in that**
the broadband amplifier is arranged in connection with a fibre node of a cable television network.
